# EUROPEAN PATENT APPLICATION

(11) **EP 3 531 511 A1**
(43) Date of publication of application: **28.08.2019**
(21) Application number: 19159521.4
(22) Date of filing: 26.02.2019
(51) Int. Cl.: H01R 12/59, H05K 13/04, H05K 13/00

(54) **DEVICE FOR ASSEMBLING AND ENCAPSULATING LIGHTING COMPONENTS IN A TEXTILE STRUCTURE, OPERATING METHOD AND USES THEREOF**

(30) Priority: 26.02.2018 PT 2018110594
(71) Applicant: Têxteis Penedo S.A., 4801-914 Guimarães (PT)
(72) Inventor: COUTOS DOS SANTOS VENTURA, Sandra Gabriela, 4801-914 GUIMARÃES (PT); DIAS AFONSO, AGOSTINHO ANTÓNIO, 4801-914 GUIMARÃES (PT); SILVA ABREU, JOÃO, 4801-914 GUIMARÃES (PT); TRINDADE MORGADO RODRIGUES, LÚCIA, 4800-039 GUIMARÃES (PT); CAMPOS DE OLIVEIRA, CRISTINA MANUELA, 4805-019 GUIMARÃES (PT); SIMÕES COSTA, HUGO FILIPE, 4760-034 VILA NOVA DE FAMALICÃO (PT); POÇAS GONÇALVES, JOSÉ JOAQUIM, 4760-034 VILA NOVA DE FAMALICÃO (PT); FARIA FERNANDES, Duarte Nuno, 4445-259 Alfena (PT); Gonçalves Camões, Luís Filipe, 4445-259 Alfena (PT); Lobato Dias Leite, Fernando, 4445-259 Alfena (PT); Alves Dinis Teixeira Torres, Pedro José, 4445-259 Alfena (PT); Correia Pereira, Carla Susana, 4445-259 Alfena (PT)
(74) Representative: Patentree

(57) **Abstract**

The present disclosure relates to a device for assembling and encapsulating a lighting component in a textile structure with conductive wires, wherein the device comprises: a laser sensor for detecting the positioning site of the lighting component in the textile structure, means for stripping said conductive wire; a tool for positioning the lighting component in the textile structure and in contact with the stripped conductive wire, which comprises two parts: a first part for lifting and separating the conductive wire and holding it secure; a second part for positioning the lighting component; means for connecting the lighting component to the conductive wire; means for encapsulating the connections and the lighting component to the textile structure.

## Description

### Technical Domain

The present disclosure relates to a device/machine or apparatus for obtaining a textile structure, in particular fabrics, which comprises incorporated LEDs (light-emitting diodes) and uses thereof.

### Background

Commercial products of large dimension (greater than 1 m²) are not common in the home textile and decoration sector with the integration of lighting systems produced on an industrial scale. It is known that one of the first challenges for the integration on an industrial scale of lighting systems into textile substrates is the integration of conductive wires for feeding and controlling the feeding systems themselves, this being a cross challenge in the smart textile area.

This is a recent and expanding area, attending to the wide disclosure of products resulting from R&TD projects. One of the most common solutions is the integration of conductive wires by embroidery technologies.

In 2015, during the International Fairs of the area, it is known that companies have presented equipment with specific characteristics for the integration of different types of conductive wires. In addition, other companies have presented concepts and projects associated with equipment technologies with the ability to embroider conductive wires and electronic devices in textile structures.

However, the integration of conductive wires is achieved by means of aesthetics embroidery technology, i.e. the conductive wires are visible on both faces of the structure.

In this context, the technique for conductive wire integration in fabrics for integrating lighting devices exploiting the jacquard technology and which the present disclosure intends to industrialize, continues to be differentiating, thus reinforcing the innovative character of the present project vis-a-vis the state of the art.

As regards LEDs integration into textile substrates, a number of companies have been identified which have made developments in this area, such as for example, Diffus (Denmark), Creation Baumann (Switzerland), Carpetlight and Forster Rohner AG (Germany and Switzerland).

Following a distinct approach, Philips has developed flexible plastic panels with embedded LED systems, Figure 8, especially designed for integration into textile structures by rolling. These components have high mechanical strength and can be integrated into clothing and furniture.

In the process of integrating the LED lighting system, assembly and encapsulation are seen as crucial steps in the process of integrating LEDs. Currently, the most common connection processes (conductive wire to LEDs) are welding, conductive epoxy/silver lacquer and/or crimping.

The welding and crimping method were the ones that obtained the best results. Welding is an effective method, presenting a time interval between the various connections equivalent to the weld solidification time (usually short).

In addition to the connection of the electronic systems with the conductive wire by welding, there is the crimping process which eliminates the risk factor of the welding options.

At the encapsulation level, various types of materials for electrical insulation/encapsulation are commercially available which can be applied by the technology to be developed. Some of the common examples are epoxies, silicones and polyurethanes. A careful choice must take into account several parameters, which can be divided into three groups: parameters affecting the placement process, namely the properties of the uncured material of which the viscosity is highlighted; curing parameters, in particular the curing time and curing conditions and parameters of the properties of the cured material such as degree of opacity, flexibility, abrasion resistance and adhesion.

Curing parameters play a critical role in the implementation of an industrial process, since they possibly may involve the use of specific equipment such as ovens (for curing single-component encapsulations); UV curing equipment (UV curing encapsulants); dispensers with mixer system (bi-component encapsulants).

The use of encapsulation equipment is, however, common in more conventional areas such as the assembly of PCBs, for which it is already possible to find several commercial solutions. Examples include Heishin's range of dispensing equipment for bi- and single-component encapsulation materials. In the particular case of dispensing systems of bi-component formulations, these are generally comprised of a mixing unit immediately before the dispenser unit.

These facts are described in order to illustrate the technical problem solved by the embodiments of the present document.

### General Description

It is in this context that textile structures incorporating LEDs (Light-emitting diodes) arise as a result of the development of the present disclosure, where design, flexibility, low energy consumption and dynamism are pronounced characteristics, thus intrinsically reacting to current trends presented.

In one embodiment, it is a machine/apparatus/device covers to incorporate LEDs into decorative textile structures with integrated elements, i.e. a structure in Jacquard fabric with conductive wires + LEDs, which in their design stand out by variety level innovation of visual effects and as a consequence in the integration methods, both with regard to the integration of conductive wires and with respect to the incorporation of the LEDs.

With the approach of the present disclosure, the method for integrating conductive wires contemplating Jacquard technology, allows wires not to be visible and thus protected against external agents, such as for example, abrasive agents. The other advantage is at the aesthetic level since it allows the wires not to be visible on the right side of the fabric, where in the case of the turned off product, it maintains an appearance equal to that of a conventional textile article.

In one embodiment, both the conductive wires and the lighting devices are integrated into the back of the fabric so that they are not visible on the product when the lighting system is in the off state. In this way, it has been possible to obtain innovative and differentiating textile solutions using a pioneering process of integration of active lighting in textiles without changing the basic properties of a textile product namely the aesthetics, flexibility, resistance to washing, touch and fall.

One of the objectives of the present disclosure is the industrialization of innovative textile solutions with integrated lighting systems (LEDs) and interactive systems that undoubtedly have technical-economic advantages and added value than state of the art and existing commercial solutions.

In one embodiment the integration of insulated conductive wires (during weaving operation) into Jacquard textile structures, the integration of textile lighting systems (LEDs) and the production of innovative textile solutions comprise an ability to promote light effects and color with appealing design with application in the market of home textiles, decoration, hotels, among others.

Currently, the various stages of the production process present vulnerabilities, which made it necessary to find viable solutions that allow the creation of an automatic line, reducing manual labor time, production time, reflected in the unit cost, adding reproducibility and capacity for large scale production, and decrease of rejected articles. The industrialization of textile structures with LEDs generically encompasses the following steps:
Creation of the design and production of the textile structure with conductive wires;
Assembly and encapsulation of LEDs to the textile (automated process);
Connection of textile and lighting systems to control hardware;
Evaluation of product performance.

In one embodiment, at the level of the assembly and encapsulation of the LEDs to the textile (automated process) a technological solution is being developed that allows them to be carried out in an automated way. To this end, this solution should perform the following tasks autonomously:
- Detecting the place where the LED is to be placed;
- Stripping the conductive wire;
- Placing the LED;
- Welding the conductive wire to the LED;
- Encapsulating the connections and LED.

One of the aspects of the present disclosure refers to a device for assembling and encapsulating a lighting component in a textile structure with conductive wires, wherein the device comprises:
a laser sensor for detecting the positioning site of the lighting component in the textile structure,
means for stripping said conductive wire;
a tool for positioning the lighting component in the textile structure and in contact with the stripped conductive wire, which comprises two parts:
   a first part for lifting and separating the conductive wire and holding it secure;
   a second part for positioning the lighting component;
means for connecting the lighting component to the conductive wire;
means for encapsulating the connections and the lighting component to the textile structure.

In one embodiment for best results, the tool for positioning the lighting component positions the lighting component below the conductive wire.

In one embodiment for best results, the textile structure is a fabric with integrated conductive wires, in particular the fabric is of the Jacquard type.

In one embodiment for best results, the device of the present disclosure may further comprise a lighting component feeder for feeding the tool for positioning the lighting component.

In one embodiment for best results, the means for connecting may be welding means, in particular arc welding.

In one embodiment for best results, the device of the present disclosure may further comprise a roller system for unwinding the textile structure.

In one embodiment for best results, the textile structure obtainable is a textile article, in particular a curtain, a tablecloth, a separator, or a folding screen.

In one embodiment for best results, the lighting component is a LED (light-emitting diode), OLED, or PCB; in particular a smaller and round PCB.

In one embodiment for best results, the laser sensor may be a camera with a laser sensor. In particular, wherein the camera is suitable for acquiring a 2D intensity profile and obtaining the 3D image with scanning.

In one embodiment for best results, the device of the present disclosure may further comprise an encapsulating material feeder.

In one embodiment for best results, the encapsulating material may be a polymer coating, in particular epoxy, silicone, polyurethane films, or mixtures thereof.

In one embodiment for best results, the means for stripping is a laser, a blade, or combinations thereof.

A further aspect of the present disclosure describes a method for operating the device for assembling and encapsulating a lighting component in a textile structure with conductive wires, comprising the following steps:
detecting the position for placing the lighting component in the textile structure;
stripping the conductive wire of the textile structure;
positioning the lighting component in the textile structure and in contact with the stripped conductive wire;
connecting the lighting component to the conductive wire, preferably by welding;
encapsulating the connections and the lighting component.

### Brief Description of the Figures

For an easier understanding of the present disclosure, figures are herein attached, which represent preferred embodiments which however are not intended to limit the object of the present disclosure.
**Figure 1****:** Representation of an embodiment of the tool for positioning the lighting component in the textile structure.
**Figure 2****:** Representation of an embodiment of the tool to assist positioning of the lighting component in the textile structure, in a real situation, wherein (1) represents the tool that lifts the wire; (2) represents the tool that carries the LEDs.
**Figure 3****:** Representation of an embodiment of the device of the present embodiment.
**Figure 4****:** Representation of an embodiment of the welding system (3) and the dispenser of the encapsulating material (4).
**Figure 5****:** Representation of an embodiment of the device of the present embodiment with the various integrated modules, wherein (5) represents the tank of the encapsulating material; (6) represents the laser; (3) represents the welding system; (4) represents the dispenser of the encapsulating material.
**Figure 6****:** Representation of an embodiment of the tool for stripping the wire (7).

### Detail Description

The present disclosure relates to a device for obtaining a textile structure with incorporated lighting system (LEDs).

The present disclosure relates to a device for assembling and encapsulating a lighting component in a textile structure with conductive wires, wherein the device comprises: a laser sensor for detecting the positioning site of the lighting component in the textile structure, means for stripping said conductive wire; a tool for positioning the lighting component in the textile structure and in contact with the stripped conductive wire, which comprises two parts: a first part for lifting and separating the conductive wire and holding it secure; a second part for positioning the lighting component; means for connecting the lighting component to the conductive wire; means for encapsulating the connections and the lighting component to the textile structure.

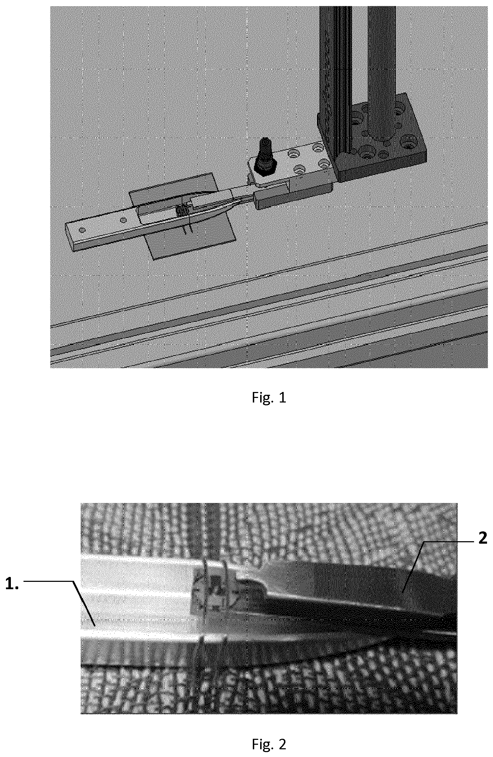

In one embodiment, for the present disclosure to work with this system of feeding the LEDs, it was necessary to develop a new tool for placing the LED on the conductive wire. This new tool comprises two main parts: one that allows lifting the conductive wire, separating the wires and keeping them fixed (1), and further protects the fabric from the processes of striping the wire with the laser and welding; another one that takes the LED from the feeder and places it below the conductive wire (2), as shown in figure 2.

In one embodiment, after the first part of this new tool having the conductive wire retained, it is necessary to strip the wire with the laser. After having the wire stripped, the next phase is to place the LED, this being made with the aid of a part carrying the LED, which is then welded to the conductive wire, using the welding system.

In one embodiment, the latter step comprises placing the glue in order to encapsulate the LED with a polymer film so as to make the textile structure, for example a curtain, more resistant and washable.

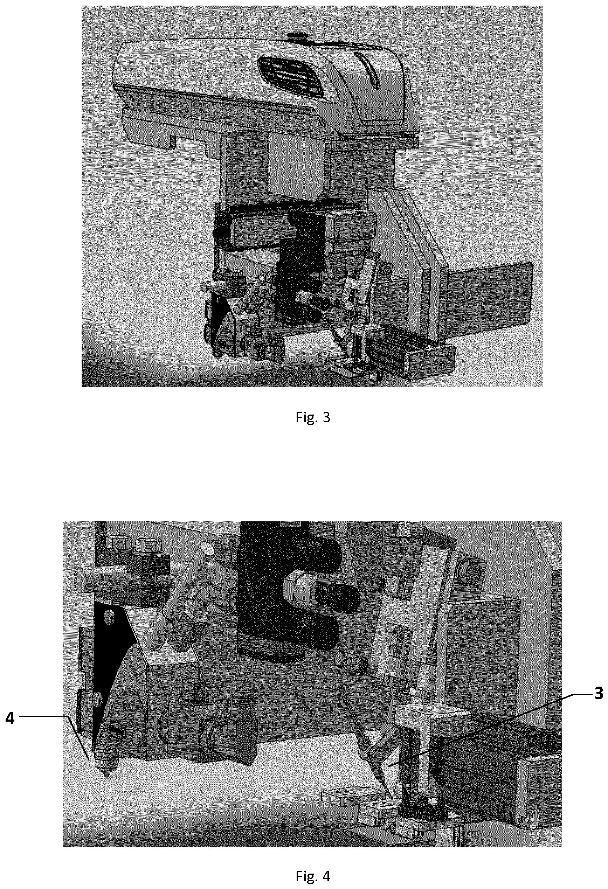

In one embodiment, the axle system being implemented in the device is shown in Figures 3 and 4. The axle system functions in conjunction with a fabric winding system. In this case, the mechanisms used will be pneumatic circuits for small movements, for example, in the movement of the LED placement tool, and electric axles for larger movements such as those for the movement of the tool arm along the fabric.

In one embodiment, for the vision system, different types of cameras were tested, including one with CCD sensor, another with infra-red and still another with laser sensor. With respect to the first two cameras, the conductive wire is well visible in both textile structures. For this reason, this type of camera has been discarded, due to the type of solution that is to be built and the type of industrial environment in which to be implemented. In addition, with this type of cameras only 2D information is available from the scene being displayed, which would make it difficult or even impossible to give the system information about whether or not the wires are lifted.

In an embodiment with best results, the choice fell on a camera with a laser sensor, which is insensitive to outdoor lighting variations. In particular, by acquiring a 2D intensity profile, but by scanning the camera produces a 3D image. In addition, the camera with laser sensor is immune to the fabric pattern, since it draws depth profiles based on the distance of the objects to the sensor.

In one embodiment, after knowing the exact position where the LED will be placed, the tool for placing the LED with the LED feeder coupled is positioned so that it can perform its task automatically. The LED feeder is similar to the sequin feeding system in a system for automatically embroidering sequins in textiles. This was only possible due to the selection of the type of LED to be used, which is now a round and smaller PCB - printed circuit board -, maintaining the lighting characteristics of the LED. Therefore, it can be fed into LED rollers.

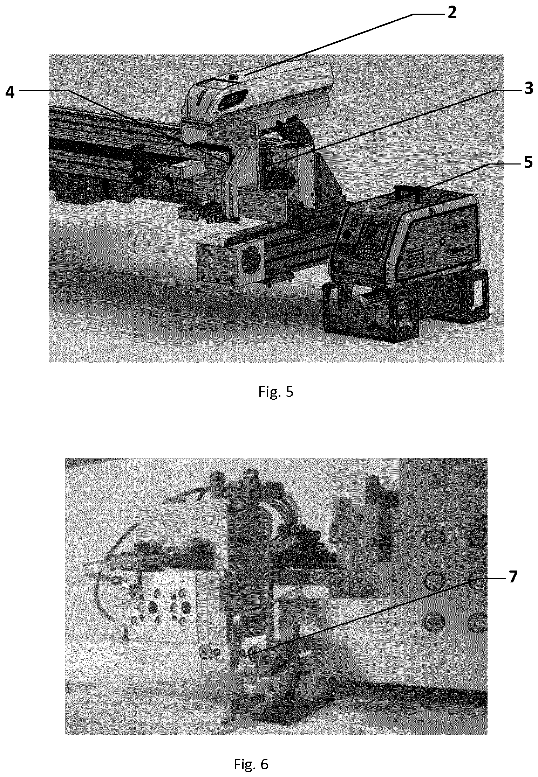

In one embodiment, the support structure of the device for placing in an industrial environment is shown in Figure 5. It has a roller system that unwinds the fabric so that it is subjected to the procedure of placing the LED, and then being once again rolled.

The term "comprises" or "comprising" when used herein is intended to indicate the presence of the features, elements, integers, steps and components mentioned, but does not preclude the presence or addition of one or more other features, elements, integers, steps and components, or groups thereof.

The embodiments described are combinable with each other.

The embodiments presented are combinable with each other. The following claims further define embodiments.

## Claims

1. Device for assembling and encapsulating a lighting component in a textile structure with conductive wires, wherein the device comprises:
a laser sensor for detecting the positioning site of the lighting component in the textile structure,
means for stripping said conductive wire;
a tool for positioning the lighting component in the textile structure and in contact with the stripped conductive wire, which comprises two parts:
a first part for lifting and separating the conductive wire and holding it secure;
a second part for positioning the lighting component;
means for connecting the lighting component to the conductive wire;
means for encapsulating the connections and the lighting component to the textile structure.

2. Device according to the previous claim wherein the tool for positioning the lighting component positions the lighting component below the conductive wire.

3. Device according to the previous claim wherein the textile structure is a fabric with integrated conductive wires, in particular the fabric is of the Jacquard type.

4. Device according to the previous claims comprising a lighting component feeder for feeding the tool for positioning the lighting component.

5. Device according to the previous claims wherein the connecting means are welding means, in particular arc welding.

6. Device according to the previous claims further comprising a roller system for unwinding the textile structure.

7. Device according to the previous claims wherein the textile structure obtainable is a textile article, in particular a curtain, a tablecloth, a separator, or a folding screen.

8. Device according to the previous claims wherein the lighting component is a LED, OLED, or PCB.

9. Device according to any of the previous claims wherein the laser sensor is a camera with laser sensor.

10. Device according to the previous claim wherein the camera is suitable for acquiring a 2D intensity profile and obtaining the 3D image with scanning.

11. Device according to the previous claims further comprising an encapsulating material feeder.

12. Device according to the previous claim wherein the encapsulating material is a polymer coating, in particular epoxy, silicone, polyurethane films, or mixtures thereof.

13. Device according to the previous claims comprising wherein the stripping means are a laser, a blade, or combinations thereof.

14. Method for operating the device for assembling and encapsulating a lighting component in a textile structure with conductive wires described in any one of the previous claims comprising the following steps:
detecting the position for placing the lighting component in the textile structure;
stripping the conductive wire of the textile structure;
positioning the lighting component in the textile structure and in contact with the stripped conductive wire;
connecting the lighting component to the conductive wire, preferably by welding;
encapsulating the connections and the lighting component.
